(19) 

**Europäisches Patentamt**

**European Patent Office**

**Office européen des brevets**

(11) **EP 4 746 594 A1**

(12) **EUROPEAN PATENT APPLICATION**
published in accordance with Art. 153(4) EPC

(43) Date of publication:
**20.05.2026 Bulletin 2026/21**

(21) Application number: **23945769.0**

(22) Date of filing: **14.07.2023**

(51) International Patent Classification (IPC):
**H05K 3/46** *(2006.01)*   **H05K 1/02** *(2006.01)*
**H05K 3/00** *(2006.01)*

(52) Cooperative Patent Classification (CPC):
**H05K 1/02; H05K 3/00; H05K 3/46**

(86) International application number:
**PCT/JP2023/025989**

(87) International publication number:
**WO 2025/017763 (23.01.2025 Gazette 2025/04)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Mitsubishi Electric Mobility Corporation**
**Tokyo 100-8310 (JP)**

(72) Inventors:
- **NAGAO, Takashi**
  **Tokyo 100-8310 (JP)**
- **MURAKAMI, Satoshi**
  **Tokyo 100-8310 (JP)**

(74) Representative: **Hoffmann Eitle**
**Patent- und Rechtsanwälte PartmbB**
**Arabellastraße 30**
**81925 München (DE)**

(54) **MULTILAYER WIRING BOARD AND POWER CONVERSION DEVICE**

(57)     A multilayer wiring board having an electrically insulating substrate (10) provided with inner layer conductors and a substrate division portion (20) includes: substrate wiring (1) connecting a current input face (30) and a current output face (40) of the substrate (10); a penetration via-hole (3) penetrating through the substrate (10) and connecting the inner layer conductors; and a non-penetration via-hole (4) connecting the layers of some of the inner layer conductors. Within the wiring of the substrate wiring (1), the non-penetration via-hole (4) is provided on the side of the substrate division portion (20) relative to the penetration via-hole (3), and a current path (50b) straightly connecting the current input face (30) and the current output face (40) via the non-penetration via-hole (4) is longer than a current path (50a) straightly connecting the current input face (30) and the current output face (40) via the penetration via-hole (3). The penetration via-hole (3) and the non-penetration via-hole (4) may be a penetration via-hole group (60) and a non-penetration via-hole group (70), respectively, each composed of a plurality of via-holes.

FIG. 4

EP 4 746 594 A1

**Description**

TECHNICAL FIELD

The present disclosure relates to a multilayer wiring board and a power conversion device provided with the same.

BACKGROUND ART

For size reduction of a power conversion device, a structure in which a control unit and a power conversion unit are formed at the same substrate using a multilayer wiring board so as to achieve high-density mounting, is being adopted. Forming the power conversion unit at the same substrate makes it possible to perform fixation of components by mounting semiconductor switching elements for power conversion and formation of current paths between the components at the same time, thus providing an advantage that the structure is simplified and the working cost for components to be mounted can be reduced.

However, meanwhile, there are a problem that heat is generated by a conductor resistance of substrate wiring, and a problem that the number of penetration via-holes for splitting current into wiring layers of the multilayer wiring board in order to reduce the resistance of the substrate wiring increases. In addition, since the number of holes to be worked by an NC drill increases, the manufacturing cost and the working time for the substrate increase, and wear of the NC drill also becomes a problem.

In addition, there is a problem that stress is applied to a mounted component when the substrate is divided into a plurality of pieces for the purpose of high-density mounting. As a measure for relaxing the stress, a method of forming penetration holes along a cutting portion between a substrate division portion and a mounted component has been shown (see, for example, Patent Document 1).

CITATION LIST

PATENT DOCUMENT

Patent Document 1: Japanese Laid-Open Patent Publication No. 2020-188227

SUMMARY OF THE INVENTION

PROBLEM TO BE SOLVED BY THE INVENTION

In a case of forming the power conversion unit of the power conversion device at the substrate, it is necessary to suppress heat generation in power semiconductors mounted to the substrate and heat generation in power lines connecting components through substrate wiring, and form an efficient heat dissipation structure while ensuring high-density mounting.

In order to reduce heat generation in the substrate wiring forming the power lines, a thick copper substrate having a thick copper foil may be used, but this does not allow the wiring pitch to be finely set and thus is not suitable to high-density wiring and high-density mounting. Therefore, it becomes necessary that, using a multilayer wiring board, copper foils of wiring layers are connected by via-holes and current is split so as to avoid increase in the current density and reduce the resistance.

Here, the via-holes connecting the wiring layers of the multilayer wiring board include a penetration via-hole obtained by forming a penetration hole in the substrate through drill working and then plating the inside thereof with copper, and a non-penetration via-hole connecting only necessary layers without being formed as a penetration hole in the substrate. In a case of having four or more layers in the substrate, an interstitial via hole (hereinafter, referred to as IVH) is used as the non-penetration via-hole. Regarding the above holes, in order to reduce the current density, it is effective to use the penetration via-hole which has a larger hole diameter than the non-penetration via-hole and has thick plating in the via-hole so as to have a low resistance.

However, there is a problem if a large number of penetration via-holes are formed, the manufacturing cost for the substrate increases due to wear of the NC drill and increase in the working time, and on the other hand, if the number of penetration via-holes is decreased, the conductor resistance of the substrate wiring increases.

For cost reduction, the substrate is formed in a certain size called a work size and panelized so as to increase the number of obtained pieces, and after circuit components are mounted, the substrate is divided to obtain a plurality of pieces. Near the substrate division portion, penetration holes are often provided along an area between the substrate division portion and the mounted component, in order to relax stress in division.

That is, in a case where a circuit component is mounted using a connection member such as solder, if the penetration holes are absent, the function of relaxing stress is lost, so that there is a possibility of causing a defect such as a crack or disconnection in the connection member and the circuit component. Therefore, if the penetration holes are absent at this part, the circuit component needs to be mounted away from the substrate division portion. Thus, it becomes difficult to reduce the size of the substrate and the number of pieces obtained from the work-size substrate decreases, so that there is a problem of causing cost reduction is hindered.

In addition, since the inside of the IVH is filled with a material such as epoxy resin or a filler, the IVH is subject to greater thermal stress due to difference in linear expansion coefficients of different materials as compared to the penetration via-hole having air therein, so that there is a problem of causing connection reliability between the via-hole and the copper foil of each wiring layer is low.

The present disclosure has been made to solve the above problems, and an object of the present disclosure is to provide a multilayer wiring board in which the number of penetration via-holes for reducing the resistance of substrate wiring is decreased, reduction in the resistance of the substrate wiring and connection reliability of the via-holes are ensured, and stress to the mounted component at the time of dividing a substrate can be relaxed.

MEANS TO SOLVE THE PROBLEM

A multilayer wiring board according to the present disclosure is a multilayer wiring board having an electrically insulating substrate in which inner layer conductors in three or more layers are provided, the multilayer wiring board being provided with a substrate division portion for dividing the substrate into a plurality of pieces, the multilayer wiring board including: substrate wiring connecting a current input face and a current output face provided at the substrate; a penetration via-hole penetrating through the substrate and connecting the inner layer conductors; and a non-penetration via-hole connecting the layers of some of the inner layer conductors, wherein within the wiring of the substrate wiring, the non-penetration via-hole is provided on the side of the substrate division portion relative to the penetration via-hole, and a current path straightly connecting the current input face and the current output face via the non-penetration via-hole is longer than a current path straightly connecting the current input face and the current output face via the penetration via-hole.

EFFECT OF THE INVENTION

According to the present disclosure, it becomes possible to provide a multilayer wiring board in which the number of penetration via-holes for reducing the resistance of substrate wiring is decreased, reduction in the resistance of the substrate wiring and connection reliability of the via-holes are ensured, and stress to the mounted component at the time of dividing a substrate can be relaxed.

BRIEF DESCRIPTION OF THE DRAWINGS

[FIG. 1] FIG. 1 is a schematic view showing a cross-section structure of via-holes according to embodiment 1.
[FIG. 2] FIG. 2 is a schematic view showing a hole pitch of penetration via-holes according to embodiment 1.
[FIG. 3] FIG. 3 is a schematic view showing a hole pitch of non-penetration via-holes according to embodiment 1.
[FIG. 4] FIG. 4 is a schematic view showing the positional relationship among substrate wiring, via-hole groups, and a substrate division portion according to embodiment 1.
[FIG. 5] FIG. 5 is a schematic view showing the positional relationship among substrate wiring, via-hole groups, and a substrate division portion according to embodiment 2.
[FIG. 6] FIG. 6 is a schematic view showing another example of the positional relationship among substrate wiring, via-hole groups, and a substrate division portion according to embodiment 2.
[FIG. 7] FIG. 7 is a block diagram showing a system configuration of a power conversion device provided with the multilayer wiring board according to each of embodiments 1 to 3.

DESCRIPTION OF EMBODIMENTS

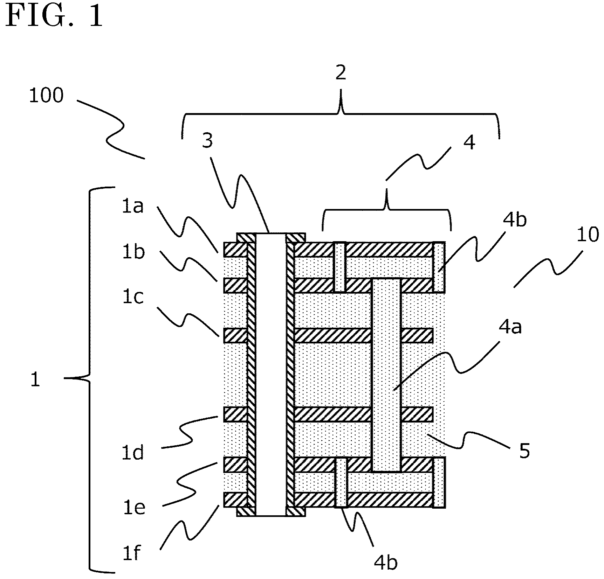

Hereinafter, embodiments will be described with reference to the drawings. In the drawings, the same reference characters denote the same or corresponding parts. FIG. 1 to FIG. 7 merely relate to embodiments and these drawings are not intended to limit the present disclosure.

Embodiment 1

FIG. 1 is a schematic view showing a cross-section structure of via-holes according to embodiment 1, and shows examples of a penetration via-hole and a non-penetration via-hole for reducing the resistance of substrate wiring.

Here, the "via-hole" comprehensively refers to an electrical and mechanical conductor structure obtained by forming a hole in the substrate and plating the inside thereof with copper so as to connect copper foils of wiring layers, for the purpose of conduction between the wiring layers. The "penetration via-hole" refers to a via-hole obtained by forming a penetration hole in the substrate by an NC drill and plating the inside thereof with copper, and the "non-penetration via-hole" refers to a via-hole that is formed by a laser beam or a small-diameter drill without being formed as a penetration hole in the substrate and connects only necessary layers by copper plating.

Other than the via-holes, a penetration hole in which a terminal of a circuit component or the like is inserted and soldered is referred to as a penetration through hole for component.

In FIG. 1, a multilayer wiring board 100 includes substrate wiring 1 forming power lines in a substrate 10, inner layer conductors 1a to 1f formed by copper foils, via-holes 2 including a penetration via-hole 3 and a non-penetration via-hole 4, and an organic insulating material 5 such as glass cloth epoxy resin provided between the inner layer conductors 1a to 1f. The non-penetration via-hole 4 is formed as an IVH and includes a buried via-hole 4a connecting the inner layer conductors 1b to 1e without being connected to the inner layer conductor 1a serving as a front layer of the substrate 10 and the inner layer conductor 1f serving as a back layer of the substrate 10 in an interlayer connection configuration, and blind via-holes 4b which are buried in the substrate 10 so as to be invisible from the surface and which connect the copper foils of the inner layer conductor 1b and the inner layer conductor 1a in the front layer and connect the copper foils of the inner layer conductor 1e and the inner layer conductor 1f in the back layer.

The insides of the buried via-hole 4a and the blind via-hole 4b are filled with a material such as epoxy resin or a filler, and the penetration via-hole 3 has air therein.

In the present disclosure, the inner layer conductors 1a to 1f of the substrate wiring 1 form a six-layer structure, and the penetration via-hole 3 connects all the layers. However, the number of layers is not limited to six, and the connection layer may have any form. Although the non-penetration via-hole 4 is formed as a connection layer of a copper foil using an IVH, the non-penetration via-hole 4 may be any non-penetration via-hole, and the connection layer has a degree of freedom and is not limited to the above structure.

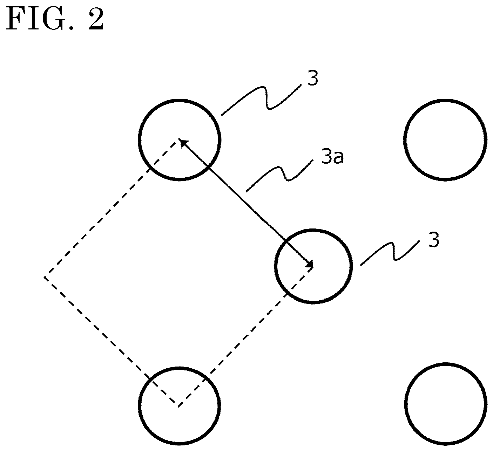

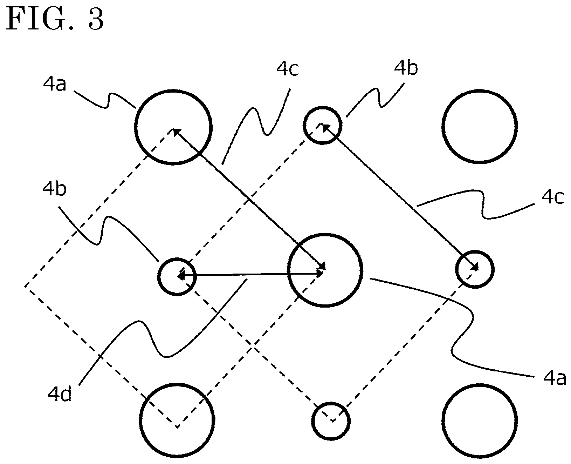

FIG. 2 is a schematic view showing a hole pitch of the penetration via-holes 3 according to embodiment 1, and shows that the minimum hole pitch is a distance 3a when the penetration via-holes 3 are arranged in a square lattice. FIG. 3 is a schematic view showing a hole pitch of the non-penetration via-hole 4 according to embodiment 1, and shows that the minimum hole pitch is a distance 4c when the buried via-hole 4a and the blind via-hole 4b which are IVHs are arranged in a square lattice as in FIG. 2.

The parts between layers connected by the buried via-hole 4a and the blind via-hole 4b which are IVHs are thin as compared to the penetration via-hole 3 and therefore the buried via-hole 4a and the blind via-hole 4b have smaller hole diameters and the hole pitches thereof can be finely set, although the copper plating thickness is small.

Meanwhile, the penetration via-hole 3 is formed by an NC drill so as to penetrate through the substrate 10, and therefore necessarily has a larger hole diameter than the non-penetration via-hole 4, and the hole pitch of the penetration via-holes 3 cannot be set to be smaller than those of the buried via-holes 4a and the blind via-holes 4b which are IVHs (distance 3a > distance 4c). However, the penetration via-hole 3 can have thicker copper plating accordingly, thus having an advantage that the penetration via-hole 3 can connect layers with a low resistance.

In FIG. 3, in a case where the buried via-holes 4a and the blind via-holes 4b have the same hole pitch in their square lattices, they are shifted from each other between layers by a hole pitch distance 4d that is $1/\sqrt{2}$ times the distance 4c, and the copper plating in the thickness direction of the substrate 10 disperses and supports stress in the thickness direction of the substrate 10 by a smaller hole pitch than the minimum hole pitch 3a at which the penetration via-holes 3 are arranged in a square lattice.

Here, as connection reliability of the multilayer wiring board 100, conduction reliability in the plating part of the via-hole 2 is considered important. As a joining part is subjected to a temperature cycle having a great temperature difference, a low cycle fatigue occurs due to nonlinear strain, and can lead to breakage in the end. It is known that the number of fatigue life cycles of the joining part conforms to the Coffin-Manson rule as shown by Formula 1.

[Mathematical 1]

$$N = C \times (\Delta\varepsilon)^{-n} \qquad \text{Formula 1}$$

N: Number of fatigue life cycles
$\Delta\varepsilon$: Nonlinear strain amplitude in joining part that occurs during one temperature cycle
C: Material constant

n: Material constant

Although the penetration via-hole 3 has air therein, the insides of the buried via-hole 4a and the blind via-hole 4b which are IVHs are filled with a material such as epoxy resin or a filler, in order to prevent denting in the shape of the substrate 10 and corrosion thereof, and in order to prevent occurrence of solder splash at the time of soldering in a reflow oven if air is present.

As described above, since the inside of the non-penetration via-hole 4 which is an IVH is filled with a material such as epoxy resin or a filler, a nonlinear strain amplitude due to a difference in linear expansion coefficients of a combination of different materials (copper: 16.5 ppm/K, epoxy resin: 45 to 65 ppm/K) occurs not only in the thickness direction of the substrate 10 as in the penetration via-hole 3 but also in the surface direction and the tangent direction of the circumference of the via-hole.

Therefore, the non-penetration via-hole 4 which is an IVH has a greater strain amplitude than the penetration via-hole 3, and in a case where the same thermal stress is applied, connection reliability of the non-penetration via-hole 4 is generally lower than that of the penetration via-hole 3.

Therefore, a part where a current path is short and a current density is high is greatly influenced by nonlinear strain due to heat generation, and accordingly, it is desirable to use the penetration via-hole 3 for such a part in order to increase connection reliability of the via-hole.

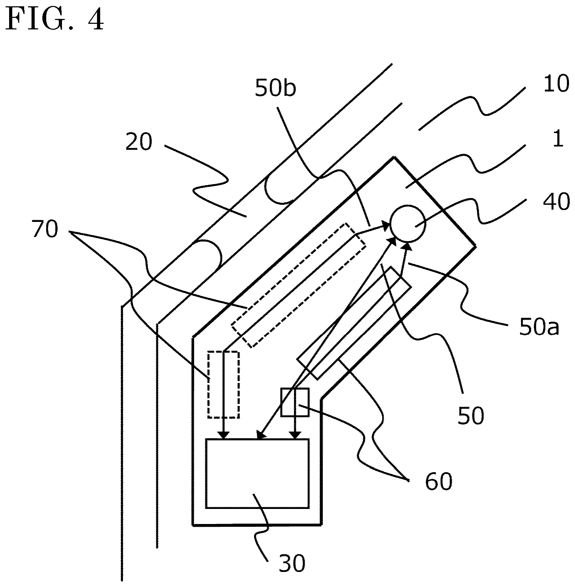

FIG. 4 is a schematic view showing the positional relationship among the substrate wiring, via-hole groups, and a substrate division portion according to embodiment 1. In a case where the shape of the substrate wiring is oblique to a current shortest path connecting a current input face and a current output face of a circuit component, i.e., is not parallel thereto, a distribution arises in the current density in the substrate wiring forming power lines. This will be described below.

In FIG. 4, the substrate wiring 1 forming power lines at a surface of the substrate 10, and a substrate division portion 20 tear-off-line worked for dividing the substrate 10 into a plurality of pieces, are provided, and on the substrate wiring 1, a current input face 30 for a surface mounted component, and a current output face 40 formed by a penetration through hole in which a terminal of a circuit component or the like is inserted and soldered for extracting current, are provided.

The substrate wiring 1 has a bent part along the outer shape of the substrate 10 and has a shape oblique to a current shortest path 50 connecting the current input face 30 and the current output face 40. A penetration via-hole group 60 composed of a plurality of penetration via-holes 3 is provided at a wiring end that faces in the inward direction of the substrate 10, and a non-penetration via-hole group 70 composed of a plurality of non-penetration via-holes 4 is provided at a wiring end that faces the side of the substrate division portion 20 in the outward direction of the substrate 10. Here, the non-penetration via-hole group 70 of IVHs has such a structure that holes cannot be seen from a surface of the substrate 10.

In this configuration, since the shape of the substrate wiring 1 is not parallel to the current shortest path 50, there is a difference between a current path length of a current path 50a connecting the current input face 30 and the current output face 40 via the penetration via-hole group 60 and a current path length of a current path 50b connecting the current input face 30 and the current output face 40 via the non-penetration via-hole group 70, within the wiring of the substrate wiring 1.

That is, on the current path 50a provided facing in the inward direction of the substrate 10, the current path length between the current input and output faces becomes relatively short, so that current concentrates and the current density increases. On the other hand, on the current path 50b provided facing in the outward direction of the substrate 10, the current path length between the current input and output faces becomes relatively long, so that the conductor resistance increases and the current density decreases.

Thus, in the substrate wiring 1, in the inward direction of the substrate 10 where the current density is high, the penetration via-hole group 60 is formed using the penetration via-holes 3, to connect layers and split current into the inner layer conductors 1a to 1f. In the substrate wiring 1, in the outward direction of the substrate 10 where the current density is low, the non-penetration via-hole group 70 is formed using the non-penetration via-holes 4 which are IVHs, to connect layers and split current into the inner layer conductors 1a to 1f.

According to the present disclosure, the part where the non-penetration via-hole group 70 is provided has a lower current density relative to the part where the penetration via-hole group 60 is provided. Therefore, even if the non-penetration via-hole 4 with thinner copper plating than for the penetration via-hole 3 is used, resistance reduction of the substrate wiring 1 can be achieved, and even if an IVH is used as the non-penetration via-hole 4, the number of the penetration via-holes 3 can be decreased without lowering connection reliability.

The non-penetration via-hole group 70 is provided, along the substrate division portion 20, in the outward direction of the substrate 10 in the substrate wiring 1, with no mounted component between the non-penetration via-hole group 70 and the substrate division portion 20 formed by tear-off-line working. Thus, stress applied to a mounted component and a connection portion at the time of dividing the substrate can be relaxed.

In embodiment 1, the current input face 30 is configured for a surface mounted component, and at the current output face 40, a penetration through hole in which a terminal of a circuit component or the like is inserted and soldered is formed. However, the input/output relationship between the current input and output faces may be reversed, and both of the current input and output faces may be faces in which a surface mounted component, or a terminal of a circuit component or the like, is inserted and soldered.

In the drawing, the configuration example in which the penetration via-hole group 60 and the non-penetration via-hole group 70 are formed at only wiring ends of the substrate wiring 1, has been shown. However, they may extend to a central part of the substrate wiring 1 as well as at the wiring ends, and the arrangement ratio and the positional relationship thereof are parameters that are designed in accordance with a designing condition such as the shape of the substrate wiring 1 and the current density thereof.

Embodiment 2

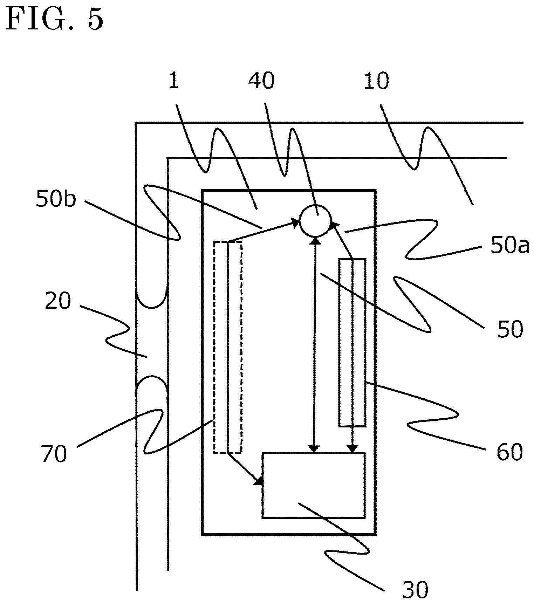

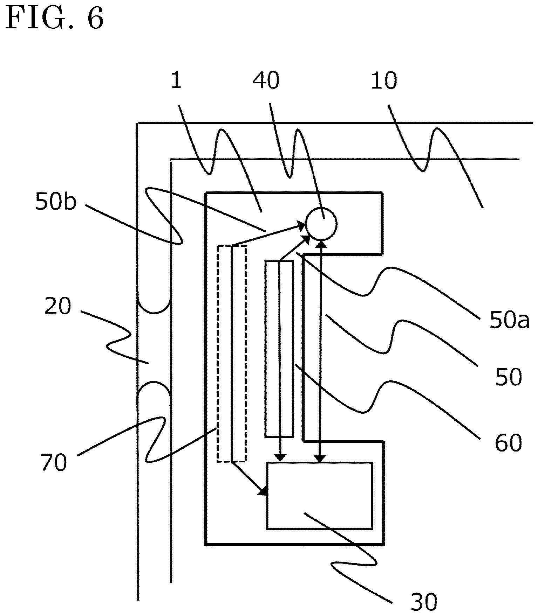

FIG. 5 and FIG. 6 are schematic views showing the positional relationship among substrate wiring, via-hole groups, and a substrate division portion according to embodiment 2. A difference from embodiment 1 is that the shape of the substrate wiring is parallel to the current shortest path connecting the current input face and the current output face of a circuit component.

That is, in embodiment 1, it has been described that, in a case where the shape of the substrate wiring 1 is oblique to the current shortest path 50, there is a difference in the current density between the wiring ends in the substrate wiring, whereas in embodiment 2, it will be described that, even in a case where the shape of the substrate wiring 1 is parallel to the current shortest path 50, there is a difference in the current density between the wiring ends in the substrate wiring.

In FIG. 5, the current shortest path 50 connecting the current input face 30 and the current output face 40 is parallel to the shape of the substrate wiring 1, and the current input face 30 and the current output face 40 are arranged offset toward the inward direction of the substrate 10 with respect to a central part of the substrate wiring 1.

In FIG. 6, the current shortest path 50 connecting the current input face 30 and the current output face 40 is parallel to the shape of the substrate wiring 1, but the current shortest path 50 is outside the substrate wiring 1.

In both examples, while the shapes of the substrate wiring 1 forming power lines are different, the current density is high in the current path 50a arranged in the inward direction of the substrate 10, and the current density is low in the current path 50b arranged in the outward direction of the substrate 10.

According to the present disclosure, the penetration via-hole group 60 is provided in the inward direction of the substrate 10 in the substrate wiring 1 and the non-penetration via-hole group 70 which is an IVH is provided in the outward direction of the substrate 10 in the substrate wiring 1. The non-penetration via-hole group 70 is provided in the substrate wiring 1 along the substrate division portion 20 with no mounted component between the non-penetration via-hole group 70 and the substrate division portion 20 formed by tear-off-line working. Thus, as in embodiment 1, increase in the conductor resistance of the substrate wiring 1 is suppressed, the number of the penetration via-holes 3 can be decreased without losing connection reliability of the via-holes, and stress in dividing the substrate can also be relaxed.

Embodiment 3

Change in arrangement of the via-holes shown in embodiments 1 and 2 will be described. The wiring shape of the substrate wiring 1 formed of power lines connecting wiring layers of the multilayer wiring board 100 may be changed between the front and back layers of the substrate 10, because of constraints due to structures of mounted components and other wiring. In this case, the blind via-holes 4b which are IVHs shown in FIG. 3 are formed such that the positional relationship and the hole pitch of arrangement in a square lattice are changed between the front and back layers.

With reference to the cross-section structure of the via-holes shown in FIG. 1, changing the arrangement relationship of the blind via-holes 4b between the front and back layers means that the blind via-holes 4b formed between the inner layer conductors 1a and 1b made of copper foils and the blind via-holes 4b formed between the inner layer conductors 1e and 1f are relatively changed in their hole pitches and the positional relationships. Thus, the degree of freedom in arrangement of via-holes with respect to the wiring shape increases, and the features described in embodiments 1 and 2 can be achieved.

Embodiment 4

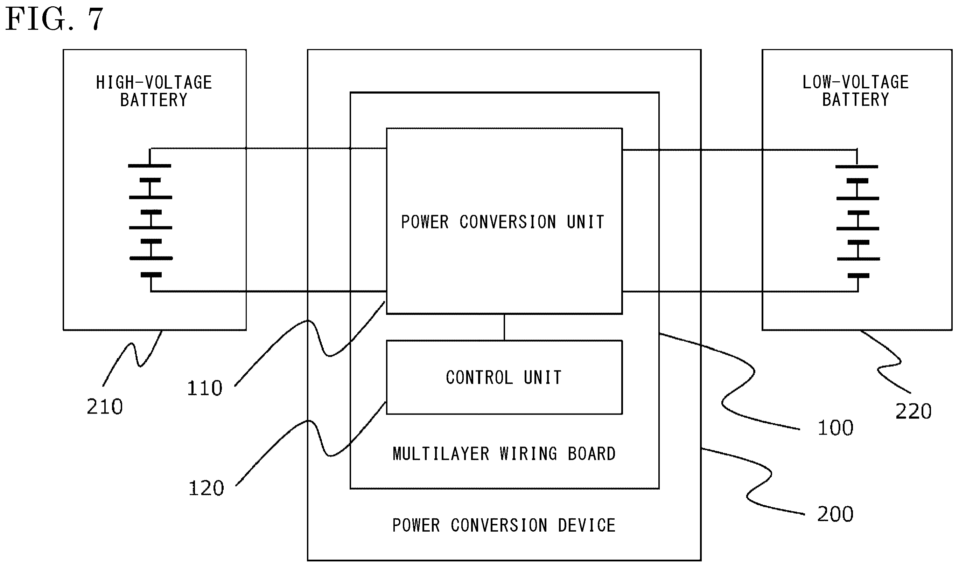

An in-vehicle charger of an electric vehicle is desired to be small in size and high in efficiency, and therefore, a case where the multilayer wiring board 100 according to the present disclosure is applied to an in-vehicle power conversion device will be described. FIG. 7 is a block diagram showing a system configuration of a power conversion device 200 provided with the multilayer wiring board 100 according to embodiments 1 to 3, and shows an embodiment as a power supply device for charging a low-voltage battery 220 with power of a high-voltage battery 210.

The power conversion device 200 is provided with the multilayer wiring board 100 having a power conversion unit 110 and a control unit 120 formed at the same substrate. The power conversion unit 110 is a circuit that performs power

# EP 4 746 594 A1

conversion using semiconductor switching elements for power conversion, and on the basis of an instruction from the control unit 120, receives input power from the high-voltage battery 210 and charges the low-voltage battery 220 connected to a load output.

According to the present disclosure, the power conversion unit 110 and the control unit 120 are formed at the same substrate, using the multilayer wiring board 100 according to each of embodiments 1 to 3, whereby high-density mounting can be achieved and thus the power conversion device 200 can be downsized.

Although the disclosure is described above in terms of various exemplary embodiments and implementations, it should be understood that the various features, aspects, and functionality described in one or more of the individual embodiments are not limited in their applicability to the particular embodiment with which they are described, but instead can be applied, alone or in various combinations to one or more of the embodiments of the disclosure.

It is therefore understood that numerous modifications which have not been exemplified can be devised without departing from the scope of the present disclosure. For example, at least one of the constituent components may be modified, added, or eliminated. At least one of the constituent components mentioned in at least one of the preferred embodiments may be selected and combined with the constituent components mentioned in another preferred embodiment.

DESCRIPTION OF THE REFERENCE CHARACTERS

| | |
|---|---|
| 1 | substrate wiring |
| 1a to 1f | inner layer conductor |
| 2 | via-hole |
| 3 | penetration via-hole |
| 3a | distance |
| 4 | non-penetration via-hole |
| 4a | buried via-hole |
| 4b | blind via-hole |
| 4c, 4d | distance |
| 10 | substrate |
| 20 | substrate division portion |
| 30 | current input face |
| 40 | current output face |
| 50 | current shortest path |
| 50a, 50b | current path |
| 60 | penetration via-hole group |
| 70 | non-penetration via-hole group |
| 100 | multilayer wiring board |
| 110 | power conversion unit |
| 120 | control unit |
| 200 | power conversion device |
| 210 | high-voltage battery |
| 220 | low-voltage battery |

**Claims**

1. A multilayer wiring board having an electrically insulating substrate in which inner layer conductors in three or more layers are provided, the multilayer wiring board being provided with a substrate division portion for dividing the substrate into a plurality of pieces, the multilayer wiring board comprising:

    substrate wiring connecting a current input face and a current output face provided at the substrate;
    a penetration via-hole penetrating through the substrate and connecting the inner layer conductors; and
    a non-penetration via-hole connecting the layers of some of the inner layer conductors, wherein
    within the wiring of the substrate wiring, the non-penetration via-hole is provided on the side of the substrate division portion relative to the penetration via-hole, and a current path straightly connecting the current input face and the current output face via the non-penetration via-hole is longer than a current path straightly connecting the current input face and the current output face via the penetration via-hole.

2. The multilayer wiring board according to claim 1, wherein
the non-penetration via-hole is an interstitial via-hole and includes a blind via-hole.

3. The multilayer wiring board according to claim 1 or 2, wherein
the penetration via-hole and the non-penetration via-hole are a penetration via-hole group and a non-penetration via-hole group, respectively, each composed of a plurality of via-holes.

4. The multilayer wiring board according to claim 3, wherein
the non-penetration via-hole group is provided along the substrate division portion with no mounted component between the non-penetration via-hole group and the substrate division portion.

5. The multilayer wiring board according to any one of claims 1 to 4, wherein
within the wiring of the substrate wiring, the penetration via-hole and the non-penetration via-hole are each connected to the substrate wiring and are formed in a thickness direction of the substrate.

6. The multilayer wiring board according to claim 5, wherein
within the wiring of the substrate wiring, the non-penetration via-hole is arranged in an outward direction of the substrate and the penetration via-hole is arranged in an inward direction of the substrate.

7. The multilayer wiring board according to any one of claims 1 to 6, wherein
the substrate wiring has a shape oblique to a current shortest path straightly connecting the current input face and the current output face.

8. The multilayer wiring board according to any one of claims 1 to 6, wherein
the substrate wiring has a shape parallel to a current shortest path straightly connecting the current input face and the current output face.

9. The multilayer wiring board according to any one of claims 1 to 8, wherein
a hole pitch and a positional relationship of a plurality of the non-penetration via-holes are relatively changed between front and back layers of the substrate.

10. The multilayer wiring board according to any one of claims 1 to 9, wherein
a plurality of the non-penetration via-holes are arranged in a square lattice.

11. A power conversion device comprising the multilayer wiring board according to any one of claims 1 to 10, wherein
a power conversion unit and a control unit are configured at the multilayer wiring board.

# FIG. 1

FIG. 2

FIG. 3

FIG. 4

FIG. 5

# FIG. 6

# FIG. 7

HIGH-VOLTAGE
BATTERY

LOW-VOLTAGE
BATTERY

POWER CONVERSION UNIT

CONTROL UNIT

MULTILAYER WIRING BOARD

POWER CONVERSION DEVICE

210

110

120

100

220

200

EP 4 746 594 A1

## INTERNATIONAL SEARCH REPORT

International application No.

**PCT/JP2023/025989**

| A. | CLASSIFICATION OF SUBJECT MATTER |
|---|---|

*H05K 3/46*(2006.01)i; *H05K 1/02*(2006.01)i; *H05K 3/00*(2006.01)i
FI:    H05K3/46 N; H05K1/02 N; H05K3/00 X

According to International Patent Classification (IPC) or to both national classification and IPC

| B. | FIELDS SEARCHED |
|---|---|

Minimum documentation searched (classification system followed by classification symbols)

H05K3/46; H05K1/02; H05K3/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT | | |
|---|---|---|---|
| Category* | Citation of document, with indication, where appropriate, of the relevant passages | | Relevant to claim No. |
| Y | JP 2016-72472 A (SUMITOMO BAKELITE CO., LTD.) 09 May 2016 (2016-05-09) paragraphs [0022]-[0029], fig. 1-3 | | 1-11 |
| Y | US 2006/0005382 A1 (UNITECH PRINTED CIRCUIT BOARD CORPORATION) 12 January 2006 (2006-01-12) paragraph [0037], fig. 6C | | 1-11 |
| Y | JP 2008-218931 A (NEC CORPORATION) 18 September 2008 (2008-09-18) paragraphs [0028]-[0034], fig. 1-2, 6A | | 1-11 |
| Y | JP 2008-198904 A (HITACHI METALS LTD.) 28 August 2008 (2008-08-28) paragraphs [0017]-[0028], fig. 1-2 | | 1-11 |
| Y | JP 2016-225395 A (SHARP KABUSHIKI KAISHA) 28 December 2016 (2016-12-28) paragraph [0024], fig. 1, 5 | | 1-11 |
| Y | JP 2020-188227 A (DENSO CORPORATION) 19 November 2020 (2020-11-19) paragraphs [0059], [0065]-[0069], fig. 1, 4 | | 1-11 |
| A | JP 2015-216300 A (DAISHO DENSHI KK) 03 December 2015 (2015-12-03) | | 1-11 |

☑ Further documents are listed in the continuation of Box C.     ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **03 October 2023** | **17 October 2023** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 **Japan** | |
| | Telephone No. |

Form PCT/ISA/210 (second sheet) (January 2015)

## INTERNATIONAL SEARCH REPORT

| International application No. |
| --- |
| **PCT/JP2023/025989** |

**C.    DOCUMENTS CONSIDERED TO BE RELEVANT**

| Category* | Citation of document, with indication, where appropriate, of the relevant passages | Relevant to claim No. |
| --- | --- | --- |
| A | JP 2000-277917 A (MITSUBISHI ELECTRIC CORPORATION) 06 October 2000 (2000-10-06) | 1-11 |
| A | JP 2009-43853 A (DENSO CORPORATION) 26 February 2009 (2009-02-26) | 1-11 |
| A | JP 2007-207781 A (FUJITSU LIMITED) 16 August 2007 (2007-08-16) | 1-11 |
| A | US 2006/0267174 A1 (MACROPOULOS, William) 30 November 2006 (2006-11-30) | 1-11 |
| A | US 11564316 B2 (LOCKHEED MARTIN CORPORATION) 24 January 2023 (2023-01-24) | 1-11 |

Form PCT/ISA/210 (second sheet) (January 2015)

**INTERNATIONAL SEARCH REPORT**
Information on patent family members

International application No.

**PCT/JP2023/025989**

| Patent document cited in search report | | | Publication date (day/month/year) | Patent family member(s) | | | Publication date (day/month/year) |
|---|---|---|---|---|---|---|---|
| JP | 2016-72472 | A | 09 May 2016 | (Family: none) | | | |
| US | 2006/0005382 | A1 | 12 January 2006 | (Family: none) | | | |
| JP | 2008-218931 | A | 18 September 2008 | US paragraphs [0057]-[0064], fig. 1-2, 6A | 2008/0218985 | A1 | |
| JP | 2008-198904 | A | 28 August 2008 | (Family: none) | | | |
| JP | 2016-225395 | A | 28 December 2016 | (Family: none) | | | |
| JP | 2020-188227 | A | 19 November 2020 | US paragraphs [0068], [0074]-[0078], fig. 1, 4 DE CN | 2020/0366165 102020205579 111954372 | A1 A1 A | |
| JP | 2015-216300 | A | 03 December 2015 | (Family: none) | | | |
| JP | 2000-277917 | A | 06 October 2000 | (Family: none) | | | |
| JP | 2009-43853 | A | 26 February 2009 | (Family: none) | | | |
| JP | 2007-207781 | A | 16 August 2007 | US KR CN TW | 2007/0175657 10-2007-0078775 101014225 200730060 | A1 A A A | |
| US | 2006/0267174 | A1 | 30 November 2006 | (Family: none) | | | |
| US | 11564316 | B2 | 24 January 2023 | WO | 2020/112481 | A1 | |

Form PCT/ISA/210 (patent family annex) (January 2015)

**REFERENCES CITED IN THE DESCRIPTION**

**Patent documents cited in the description**

- JP 2020188227 A